Europäisches Patentamt

**European Patent Office**

**Office européen des brevets**

(19)

(11) Publication number: **0 128 603**
A1

# (12) EUROPEAN PATENT APPLICATION

(21) Application number: **84200670.2**

(22) Date of filing: **10.05.84**

(51) Int. Cl.³: **H 03 K 19/013,** H 03 K 19/088

(30) Priority: **13.05.83 US 494490**

(43) Date of publication of application: **19.12.84**
**Bulletin 84/51**

(84) Designated Contracting States: **DE FR GB IT**

(71) Applicant: **N.V. Philips' Gloeilampenfabrieken,**
**Groenewoudseweg 1, NL-5621 BA Eindhoven (NL)**

(72) Inventor: **Smith, Douglas Duke, c/o INT.**
**OCTROOIBUREAU B.V. Prof. Holstlaan 6, NL-5656 AA**
**Eindhoven (NL)**

(74) Representative: **Faessen, Louis Marie et al,**
**INTERNATIONAAL OCTROOIBUREAU B.V. 6 Prof.**
**Holstlaan, NL-5656 AA Eindhoven (NL)**

(54) **Transistor-transistor logic circuit with switchable current feedback.**

(57) A transistor-transistor logic (T²L) circuit uses a switchable feedback network to enhance the negative-going output switching characteristics of the circuit. The switchable feedback network includes a Schottky diode (D2) in series with the collector-emitter path of a feedback transistor (Q5), connected between the output terminal (3) of the circuit and the collector zone of a phase-splitter transistor (Q1). The base zone of the feedback transistor (Q5) is connected to the intermediate node (6) of a Darlington pull-up amplifier (Q2, Q3) in the T²L circuit, so that the feedback network is activated only during the negative-going output transition. This configuration provides a circuit in which a superior negative-going switching transition characteristic is obtained, while at the same time preventing malfunction and possible damage to the device resulting from unwanted external current feedback.

Transistor-transistor logic circuit with switchable current feedback.


# BACKGROUND OF THE INVENTION


## Field of the invention


This invention is in the field of transistor-transistor logic ($T^2L$) circuits suitable for use in semiconductor integrated circuit devices, and relates more particularly to a transistor-transistor logic ($T^2L$) circuit which comprises:

input circuit means comprising a phase splitter and having an input terminal, an in-phase output node, and an inverting output node;

pull-down output means having an input node coupled to the in-phase output node of said phase splitter, an output node, and a common terminal coupled to ground;

pull-up output means comprising a Darlington amplifier having an input node coupled to the inverting output node of said phase splitter, an intermediate node, a common node coupled to said power supply terminal, and an output terminal coupled to the pull-down output node.

## Description of the Prior Art

Logic circuits of the general transistor-transistor logic ($T^2L$) type are well known in the art. A basic $T^2L$ circuit, and a description of its operation, can be found on page 312 of the standard reference text <u>Analysis and Design of Integrated Circuits</u> (Motorola series in solid-state electronics), McGraw-Hill, 1967. Such circuits employ a phase-splitter transistor with a Darlington pull-up output amplifier having its input connected to the collector zone of the phase-splitter transistor and a pull-down transistor having its input connected to the emitter zone of the phase-splitter transistor. The Darlington pull-up amplifier and the pull-down transistor outputs are

0128603
01-03-84

connected together to form the circuit output terminal.

Such circuits have been widely used for several reasons, including their ability to drive heavy loads in either state, and in particular their ability to drive large capacitive loads.

However, the basis $T^2L$ circuit suffers from a disadvantage in that the high-to-low or negative-going transition at the output terminal may be somewhat slower than is desired, particularly for large capacitive loads. Since one of the main advantages of the $T^2L$ configuration is its ability to drive such large capacitive loads, a $T^2L$ circuit in which this high-to-low transition is enhanced would be particularly desirable.

Accordingly, several modifications to the basic $T^2L$ circuit have been developed to improve this output level transition. For example, one well-known expedient (used, for example, in several Texas Instruments $T^2L$ devices) has been to add a diode connected from the output terminal of the circuit to the collector zone of the phase-splitter transistor in order to couple back a portion of the output signal through the phase-splitter transistor to the base zone of the pull-down transistor in order to speed up the turn-on time of the latter transistor. As a result, the output signal is pulled to ground more rapidly, particularly when driving a large capacitive load.

Another prior-art feedback technique for improving the negative-going output transition in a $T^2L$ circuit is shown in Japanese Kokai No. 56-25831, in which a diode and a feedback transistor are connected in series between the output terminal of the circuit and the base zone of the pull-down transistor. The base zone of the feedback transistor is connected to the base zone of the phase-splitter transistor, so that the base-emitter junctions of the phase-splitter and feedback transistors are connected in parallel. In this manner a portion of the output signal current is fed back directly to the base of the pull-down transistor as it is turning "on" to effect a

0128603
01-03-84

more rapid change in state.

However, both of these prior-art circuits suffer from a significant drawback. In both cases, the prior-art circuits provide a feedback path which remains undirectionally conductive either continuously (for the simple diode circuit) or at least for the entire time the circuit is in the "low" output state (as in the Japanese reference). As a result, it is possible for an externally-generated back current, such as a reflected load current or a D.C. forcing signal on the output, to drive a high current level back drom the output terminal to the base-emitter junction of the pull-down transistor. This increased base drive to the pull-down transistor, at a time when a heavy current drive is also provided to the collector terminal of this transistor, may result in excessive current flow through the transistor, possibly causing a malfunction or permanently damaging the pull-down transistor or its associated metal lines. Additionally, when these prior-art $T^2L$ circuits are operated in combination with other circuitry using a higher power supply voltage, it is possible to have unwanted current pumping back into the $T^2L$ circuit and its power supply from the external higher-voltage power supply.

Accordingly, it would be desirable to provide a $T^2L$ circuit with a feedback circuit for improved negative-going output transition characteristics while at the same time protecting the device against unwanted reflected load current or current pumping which may damage the device or impede its operation.

## SUMMARY OF THE INVENTION

It is therefore an object of the invention to provide a $T^2L$ circuit which employs a feedback network for an improved high-to-low output transition, in particular for high capacitive loads, while at the same time affording protection against the unwanted injection of reflected or pumped current back into the circuit.

A further object of the invention is to provide such a self-protecting $T^2L$ circuit in which the negative-

0128603
01-03-84

going output transition time is equal to or better than that of prior-art circuits without this self-protecting feature.

In accordance with the invention, these objects are achieved by an improved $T^2L$ circuit of the type described above characterized in that switchable feedback means are provided for selectably coupling the output terminal of the circuit to the inverting output node of the phase-splitter and comprising a control node connected to the intermediate node of the Darlington amplifier for switching said feedback means. This switchable feedback netwotk includes a diode connected in series with the collector-emitter path of a feedback transistor, with the base zone of this transistor forming the control node of the feedback network. By connecting this control node to the intermediate node of the Darlington amplifier (the connection point between the emitter zone of the input Darlington transistor and the base zone of the output Darlington transistor) an active switchable feedback network is obtained which is activated only during the negative-going output transition when feedback is desired, and which is rendered passive during the remainder of the operating cycle to prevent unwanted and potentially damaging current feedback.

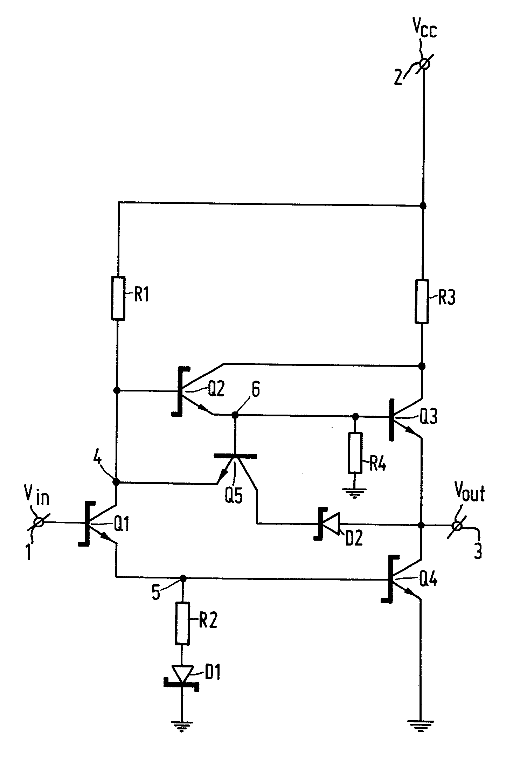

The invention may be more completely understood with reference to the following description of the preferred embodiment, to be read in conjunction with the accompanying drawing.

### BRIEF DESCRIPTION OF THE DRAWING

The single FIGURE is a schematic diagram of a $T^2L$ circuit in accordance with a preferred embodiment of the invention.

### DESCRIPTION OF THE PREFERRED EMBODIMENT

A preferred embodiment of an improved $T^2L$ circuit in accordance with the invention is shown in the single Figure of the drawing. An input signal $V_{in}$ is applied to an input terminal 1 which is connected to the base zone of a phase-splitter transistor Q1. The collector zone of this transistor, which forms an inverting output node 4 of the phase-splitter, is connected through a resistor R1 to a power supply terminal 2 $(V_{cc})$. The emitter zone of Q1, which forms an in-phase output node 5 of the phase-splitter is connected to ground through a resistor R2 and a Schottky diode D1.

The collector zone of transistor Q1 is also connected to the base zone of Schottky transistor Q2, with the collector zone of this transistor being connected to power supply terminal 2 through a resistor R3. The emitter zone of transistor Q2 is connected to the base zone of transistor Q3 at an intermediate node 6, and the collector zone of transistor Q3 is connected to the collector of transistor Q2. Together, transistors Q2 and Q3 form the first and second transistors, respectively, of a Darlington pull-up amplifier. The emitter zone of transistor Q3 is connected to terminal 3 $(V_{out})$, which is the circuit output terminal, and a bleeder resistor R4 is connected from the base zone of transistor Q3 to ground.

The emitter zone of Schottky transistor Q1, which forms the in-phase output node 5 of the phase-splitter, is also connected to the base zone of Schottky pull-down transistor Q4, while the emitter zone of the pull-down transistor is connected to ground and its collector zone is connected to output terminal 3.

The circuit as so far described forms a typical Schottky $T^2L$ circuit representative of the type used in semiconductor integrated circuits. It should be recognized that many minor variations in this basic $T^2L$ circuit (Such as the use of a transistor in the bypass network, shown in the Figure as a simple series connection of resistor R2 and diode D1, or the elmination of collector resistor R3) are possible, but that such minor variations do not affect the operation of the invention, which has general applicability in $T^2L$ circuits.

The improved performance of the invention is attributable to a switchable feedback network for selectably coupling the output terminal 3 to the inverting output node 4 of the phase-splitter transistor, at the collector of Q1. This switchable feedback network includes a Schottky diode D2 having its anode connected to the output terminal 3, and a transistor Q5 with its collector zone connected to the cathode of diode D2, its base zone connected to intermediate node 6 of the Darlington amplifier, and its emitter zone connected to the inverting node 4 of the phase-splitter transistor Q1.

The switchable feedback network composed of transistor Q5 and diode D2 is controlled by the application of a signal from intermediate node 6 of the Darlington amplifier to the base zone of Q5, with a feedback path from the output terminal 3 to the inverting node 4 being formed when transistor Q5 is turned "on", and being opened when this transistor is turned "off".

The operation of the basic $T^2L$ circuit is well known in the art, and is described on pages 312-313 of the Motorola reference text mentioned above. Accordingly, the operational description of the present circuit will be primarily directed to a description of the switchable feedback network of the invention. As mentioned above, a feedback network in a $T^2L$ circuit should ideally provide the desired feedback during the high-to-low transition of the output stage to speed up this transition, while preventing unwanted and possibly damaging current feedback during other portions of the operating cycle. In order to accomplish both of these results, the present invention utilizes switching transistor Q5 in a unique configuration. By connecting the base zone of transistor Q5 to the intermediate node 6 of the Darlington amplifier and the emitter zone of transistor Q5 to the inverting node 4 at the collector of Q1, transistor Q5 will be turned "off" in both steady-state output conditions of the $T^2L$ circuit. In the "high" output state, transistors Q2 and Q3 are "on", so that the base zone of transistor Q5 (connected to the emitter of transistor Q2) will be at a sligtly lower potential than that of the emitter zone of transistor Q5, which is connected to the base zone of transistor Q2, so that transistor Q5 is fully "off". In the "low" output state, transistors Q2 and Q3 are "off", so that intermediate node 6 of the Darlington amplifier will be at substantially ground potential due to bleeder resistor R4, while the emitter zone of transistor Q5 at inverting node 4 will be above ground by a voltage equal to the collector-emitter saturation voltage of transistor Q1 plus the base-emitter voltage of transistor Q4, since both of these latter transistors are "on" when the output is "low". Thus, the feedback network is rendered non-conductive during both steady-state operating conditions of the circuit. In this manner, unwanted and potentially damaging current feedback during steady-state operation is prevented.

However, during the negative-going switching transition of the output level, a unique transient condition exists which permits feedback transistor Q5 to be activated at precisely the right time to provide the desired feedback to speed up the negative-going transition.

In order to more fully understand the operation of the circuit of the invention, this transient condition will now be dȝscribed in further detail. In the "high" output state, transistors Q2 and Q3 are "on", while transistors Q1 and Q4 are "off". Thus, nodes 3, 4 and 6 are all "high", while node 5 is "low". In this steady-state condition, transistor Q5 is "off", as previously described because its emitter zone is at a slightly higher potential than its base zone. When a positive-going input signal $V_{in}$ is applied to input terminal 1, phase-splitter Q1 is turned "on", causing node 4 to go "low". This change in voltage level at node 4, which is also the input node of Darlington amplifier Q2, Q3, will subsequently cause the Darlington transistors to switch "off". However, transistor Q2 will not switch "off" until some finite time after transistor Q1 has turned "on", thus permitting the voltage at node 6 to remain "high" after the voltage at node 4 begins dropping. Additionally, the voltage at node 6 will remain "high" for an interval after both Darlington tran-

0128603
01-03-84

sistors are turned "off", because of the stored charge remaining on the base of transistor Q3. By making resistor R4 suitably large, for example in the range of about 10,000 ohms or greater, this stored base charge will be discharged to node 4 primarily through the base-emitter junction of transistor Q5. Thus, at the negative-going output transition, transistor Q5 is initially turned "on" by a positive voltage on node 6 with respect to node 4, and is maintained in the "on" condition until the stored base charge of transistor Q3 is discharged through the base-emitter junction of transistor Q5 to node 4. At this point transistor Q5 will return to the "off" state, where it will remain until the next negative-going output transition. Transistor Q5 is not turned "on" during the positive-going output transition, however, because transistor Q1 turns "off" (thus raising the emitter voltage of Q5 at node 4) before transistor Q2 goes "on" to raise the base voltage of transistor Q5 at node 6.

Thus, by advantageously employing the inherent switching delays and base charge storage characteristics of the $T^2L$ circuit, the present invention provides a simple and yet effective way of speeding up the negative-going output transition without risking the danger of unwanted and possibly dangerous current feedback from outside the circuit during other portions of the operating cycle.

An additional advantage of the present invention, confirmed by computerized circuit simulation, is that the negative-going switching time is somewhat faster than for the simple prior-art diode feedback circuit. This is believed to be because current feedback from node 6 and through the base-emitter junction of transistor Q5 will begin slightly sooner than current feedback from output node 3 and thorugh diode D2 because, at the start of the negative-going transition, node 6 is at a higher potential than node 3.

Methods for manufacturing the various elements of the present $T^2L$ circuit are well known in the semiconductor

0128603
01-03-84

art, and the circuit of the invention may be manufactured as a monolithic integrated circuit using conventional processing technology.

While the invention has been particularly shown and described with reference to a preferred embodiment thereof, it will be understood by those skilled in the art that various changes in form and detail may be made by those skilled in the art without departing from the spirit and scope of the invention.

0128603
01-03-84

1.        A transistor-transistor logic ($T^2L$) circuit which comprises:

input circuit means comprising a phase splitter and having an input terminal, an in-phase output node, and an inverting output node;

pull-down output means having an input node coupled to the in-phase output node of said phase splitter, an output node, and a common terminal coupled to ground;

pull-up output means comprising a Darlington amplifier having an input node coupled to the inverting output node of said phase splitter, an intermediate node, a common node coupled to said power supply terminal, and an output terminal coupled to the pull-down output node; characterized in that switchable feedback means are provided for selectably coupling said output terminal to the inverting output node of said phase splitter and comprising a control node connected to the intermediate node of said Darlington amplifier for switching said feedback means.

2.        A $T^2L$ circuit as claimed in Claim 1, wherein said switchable feedback means comprises a diode connected in series with the collector-emitter path of a feedback transistor, the base zone of said transistor comprising said control node and being connected to the intermediate node of said Darlington amplifier.

3.        A $T^2L$ circuit as claimed in Claim 2, wherein said diode is a Schottky diode.

4.        A $T^2L$ circuit as claimed in Claim 3, wherein said feedback transistor is an n-p-n transistor, the anode of said diode is connected to said output terminal, the cathode of said diode is connected to the collector zone of said transistor, and the emitter zone of said transistor is connected to the inverting output node of said phase splitter.

5.      A transistor-transistor logic $(T^2L)$ circuit, as claimed in Claim 1, which circuit comprises:

a phase-splitter transistor having a base zone which forms the input terminal of said circuit, a collector zone which forms an inverting output node and an emitter zone which forms an in-phase output node;

a first resistor connected between said phase-splitter collector zone and a power supply terminal;

a second resistor and a first diode connected in series between said phase-splitter emitter zone and ground, the polarity of said first diode being such as to conduct current between said emitter zone and ground;

a Darlington pull-up amplifier having first and second transistors, the collector zones of said first and second transistors being connected together at a common junction and said common junction being connected to said power supply terminal by a third resistor, the base zone of said first transistor being connected to the collector of said phase-splitter transistor, and the emitter zone of said first transistor being connected to the base zone of said second transistor;

a fourth resistor connected from the base zone of said second transistor to ground;

a pull-down transistor having a base zone connected to the emitter zone of said phase-splitter transistor, an emitter zone connected to ground, and a collector zone connected to the emitter zone of said second transistor at a junction which forms the output terminal of said circuit;

a feedback transistor having a base zone connected to the base zone of said second transistor, an emitter zone connected to the collector zone of said phase-splitter transistor, and a collector zone; and

a second diode connected from said output terminal to said feedback transistor collector zone, the polarity of said second diode being such as to conduct current between said output terminal and said feedback transistor.

6.        A $T^2L$ circuit as claimed in Claim 5, wherein said transistors are n-p-n transistors; said phase-splitter transistor, said first Darlington transistor and said pull-down transistor are Schottky transistors; and said first and second diodes are Schottky diodes.

0128603

European Patent
Office

**EUROPEAN SEARCH REPORT**

Application number

EP 84 20 0670

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| X | US-A-4 081 695 (G.H. ALLEN et al.) <br> * Figure 2, column 1, lines 22-39; column 2, lines 9-26; column 3, line 33 - column 4, line 33; column 4, lines 48-52; claims 1-3 * | 1-4 | H 03 K 19/013 <br> H 03 K 19/088 |
| Y | * Figure 2 * | 5,6 | |
| | --- | | |
| Y | EP-A-0 072 694 (FUJITSU LTD) <br> * Figures 3, 4A * | 5,6 | |
| | --- | | |
| D,A | Patent Abstracts of Japan vol. 5, no. 78, 22 May 1981 page 40E58 & JP-A-56-25831 | | |
| | --- | | TECHNICAL FIELDS SEARCHED (Int. Cl. ³) |
| P,A | WO-A-8 401 066 (ADVANCED MICRO DEVICES INC.) | | H 03 K 19/013 <br> H 03 K 19/088 |
| | --- | | |
| A | E.D.N. ELECTRICAL DESIGN NEWS, vol. 27, no. 23, November 1982, Boston, Massachussetts, USA; R.H. CUSHMAN "TTL enhancements and extensions", pages 95-102 <br> * Figure 2 * | | |
| | ----- | | |

The present search report has been drawn up for all claims

| Place of search <br> BERLIN | Date of completion of the search <br> 31-07-1984 | Examiner <br> ARENDT M |
|---|---|---|